# EUROPEAN PATENT SPECIFICATION

(11) **EP 1 197 995 B1**
(45) Date of publication and mention of the grant of the patent: **05.01.2011**
(21) Application number: 01124422.5
(22) Date of filing: 11.10.2001
(51) Int. Cl.: C30B 25/02, C30B 29/40, H01L 21/205

(54) **Method for fabricating a group III nitride film**
Verfahren zur Herstellung einer Schicht aus einer Nitridverbindung der Gruppe III
Méthode de fabrication d'une couche en nitrure d'éléments du groupe III

(30) Priority: 13.10.2000 JP 2000313033
(43) Date of publication of application: 17.04.2002
(73) Proprietor: NGK Insulators, Ltd., Nagoya City, Aichi Pref. (JP)
(72) Inventor: Shibata, Tomohiko, c/o NGK Insulators, Nagoya City, Aichi Pref. (JP); Nakamura, Yukinori, c/o NGK Insulators, Nagoya City, Aichi Pref. (JP); Tanaka, Mitsuhiro, c/o NGK Insulators, Nagoya City, Aichi Pref. (JP)
(74) Representative: TBK-Patent

(56) References cited:
- SATO K ET AL: "Low temperature growth of epitaxial AlN films on sapphire" IEEE 1985 ULTRASONICS SYMPOSIUM. PROCEEDINGS. (CAT. NO.85CH2209-5) IEEE NEW YORK, NY, USA, 1985, pages 192-197 vol.1, XP008064693
- PATENT ABSTRACTS OF JAPAN vol. 008, no. 185 (E-262), 24 August 1984 (1984-08-24) -& JP 59 075622 A (NIHON SANSO KK), 28 April 1984 (1984-04-28)
- PATENT ABSTRACTS OF JAPAN vol. 009, no. 140 (E-321), 14 June 1985 (1985-06-14) & JP 60 021518 A (NIPPON DENSHIN DENWA KOSHA), 2 February 1985 (1985-02-02)
- KANEKO S.; TANAKA M.; MASU K.; TSUBOUCHI K.; MIKOSHIBA N.: "Epitaxial growth of AlN film by low-pressure MOCVD in gas-beam-flow reactor" JOURNAL OF CRYSTAL GROWTH, vol. 115, 1 December 1991 (1991-12-01), pages 643-647, XP322870 Amsterdam, Netherlands ISSN: 0022-0248

## Description

### Field of the invention

This invention relates to a method for fabricating a III nitride film, particularly to a method for fabricating an Al-including III nitride film which is suitable for semiconductor devices such as a light-emitting diode or a high speed IC chip.

### Related art statement

Al-including III nitride films are used as semiconductor films for light-emitting diodes, and recently get attention as semiconductor films for high speed IC chips.

Conventionally, such an Al-including film is fabricated by a metalorganic chemical vapor deposition (MOCVD) method in which trimethylaluminum (TMA) and triethylaluminum (TEA) are employed as an Al supply source, and ammonia (NH₃) is employed as a nitrogen supply source.

In this case, a substrate on which the III nitrogen film is formed is set on a susceptor installed in a reactor and is heated to around 1000°C by a heater provided in or out of the susceptor. Then, the Al supply source, the nitrogen supply source and another supply source including another additive element, with a given carrier gas, are introduced into the reactor and supplied onto the substrate.

Just then, the supply sources thermochemically react on the substrate, and the thus decomposed constituent elements chemically react to deposit a desired Al-including III nitride film on the substrate.

However, as the Al content of the III nitride film is increased, the film suffers from moisture component in the reactor, resulting in the increase of the oxygen content to be incorporated in the film. As a result, the crystallinity of the III nitride film is deteriorated, and thus, the electric and optical properties of the film are also deteriorated.

In order to repress the oxygen content of the III nitride film, an attempt is made for baking the reactor and reducing the oxygen content and oxygen-contained impurities content of the above supply sources. However, the above-mentioned attempt is strongly influenced by environmental condition such as humidity and temperature of environmental atmosphere. Therefore, the initial operation condition can not always reduce the oxygen content of the film-sufficiently.

Moreover, the above-mentioned operation condition such as the baking operation takes long time, and makes the whole manufacturing process of the film complicated.

Therefore, it is desired to find out a physical parameter to control the oxygen content to be incorporated in the III nitride film, and establish an absolute means to reduce the oxygen content by controlling the physical parameter.

### Summary of the Invention

Document XP008064693: "Low temperature growth of epitaxial AlN films on sapphire" of K. Sato et al., IEEE 1985 Ultrasonics Symposium, vol. 1, pages 192-197, 1985, discloses a low temperature growth of epitaxial AlN films on sapphire. Specifically, an aluminium nitride (AlN) film on sapphire, which has a potential advantage for fabrication of zero temperature coefficient SAW delay line. Using a normal pressure MOCVD, epitaxial AlN films on R-plane sapphire have been grown at substrate temperature above 1000°C in a growth system. The MOCVD process has several problems such as surface degradation due to vapour phase reaction, surface nonuniformity, defect formation due to thermal stress, poor reproducibility and so on. To overcome the problems, we investigated the growth of AlN films by a low pressure MOCVD (LP-MOCVD) and a plasma enhanced MOCVD (PE-MOCVD) using trymethylaluminum (TMA) and NH₃ reactants. It was found that O₂ and H₂O contamination in the reactor should be avoided to improve the reproducibility of the crystallinity.
Furthermore, the document XP 000322870: "Epitaxial growth of AlN film by low-pressure MOCVD in gas-beam-flow reactor" of S. Kaneko et al., Journal of Crystal Growth, vol. 115, pages 643-647, December 1991, discloses an epitaxial growth of AlN film by low-pressure MOCVD in a gas-beam-flow reactor. Specifically, a "gas-beam-flow" condition and "gas-beam-flow" type reactors for epitaxial AlN growth using trymethylaluminum (TMA) and ammonia (NH₃) are suggested. By flow visualization experiments, two gas flows of the sheath and the source were found to be laminar at atmospheric and at low pressures in the "gas-beam-flow" condition. The source gas flowed without touching the reactor wall. By using the gas-beam-flow" type reactor, growing epitaxial AlN films at low temperature of 690°C with a superior surface morphology was achieved. The dew point of H₂ gas was below -100°C and high purity TMA and NH₃ were used for AlN growth. The residual oxygen in TMA was below 2 ppm. The residual moisture and oxygen in NH₃ was below 0,5 ppm.

Moreover, the related abstract of document JP 59 075622 discloses a manufacture of a semiconductor by an organic metal vapor growth method. Specifically, it is aimed to produce heterogeneous surface bonding of high performance by efficient removal of trace amount of oxygen or water content remained in the gas pipe or contained in the air or the material gas entering into by leakage by purging with aluminum alkyl supplied for supplying pipes of various material gas and for an oven heated up to a specified temperature. More precisely, trimethylaluminum (TMA) was introduced into the pipes and the oven (reactor) where temperature was kept at 70~300°C , and then hydrogen gas was introduced to clean said pipes and oven. After that the temperature was raised up to predetermined crystal growth temperature and a material gas desired (e.g. A₁H₃ + (TMA+) TMG) according to the crystal to be grown (in that case: Ga (Al)As) was introduced into the oven (reactor). When TMA is introduced into the pipes and the oven in advance of crystal growth, TMA adheres water contained in various material gas flowing in the pipes or the oven after said introduction take place furious reaction with residual TMA and are continously removed. Consequently crystal growth (here of Ga (Al)As) is mode excel lently and elements of high performance are obtained.
Further, the related patent abstract of document JP 60 021518 discloses a vapor growth method of a III-V group compound semiconductor. Specifically, it is aimed to capture the oxygen remaining in the growth region and to obtain high quality growth layer by adding an organic metal compound including Al, in the constant concentration, into the raw material gas during vapor growth of the III-V group compound semiconductor.

It is an object of the present invention to provide a physical parameter to control the oxygen content to be incorporated in an Al-including III nitride film and thus, a method capable of reducing the oxygen content.

In order to achieve the above object, this invention relates to a method as set forth in the appended in dependent claim with advantageous modifications as defined in the appended dependent claims.

The inventors have intensely studied the physical parameter to control the oxygen content to be incorporated in the Al-including III nitride film when the film is fabricated by a MOCVD method. Then, first of all, they made an attempt to discover the cause of the oxygen incorporation into the III nitride film.

As a result, they found out that the oxygen incorporation results mainly from the moisture component adsorbing to the inside of the reactor. Therefore, they made an attempt to develop a method for determining the amount of the moisture component directly or indirectly.

As the result of enormous research and experiment, they have found out a dew point measuring method as an indirect determining method of the amount of moisture component. That is, they found out that the dew point of the inside of the reactor can be associated with the oxygen amount to be incorporated in the Al-including III nitride film almost in one-to-one relation.

Therefore, if the dew point of the inside of the reactor is employed and observed as the physical parameter, the oxygen content to be incorporated in the Al-including III nitride film can be controlled.

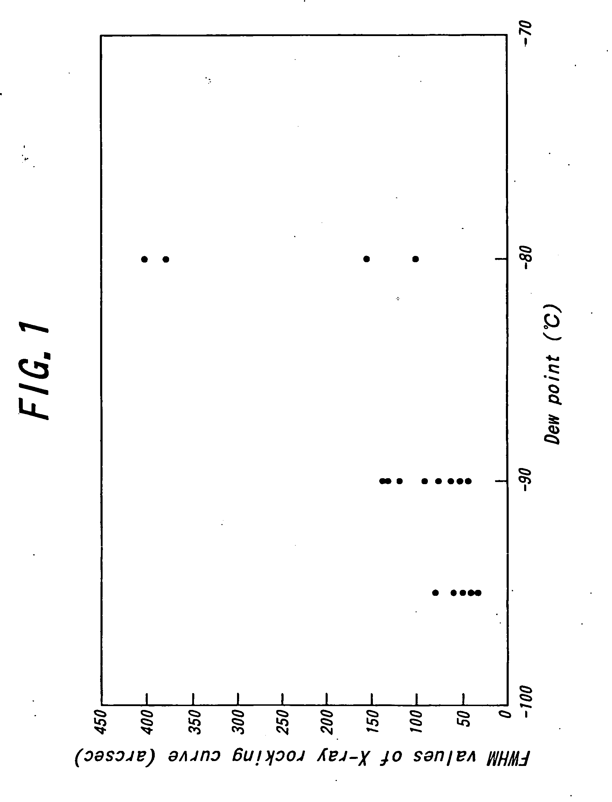

They also found out from the above enormous research and experiment that if the dew point of the inside of the reactor is set to a temperature of -90°C or below, the oxygen content of the Al-including III nitride film is reduced remarkably, so that the optical and electrical properties of the film are almost not deteriorated.
For better understanding of the present invention, reference is made to the attached drawing, wherein
Fig. 1 is a graph showing the relation between the dew point of the inside of a reactor to be used in a MOCVD method and full width at half maximum (FWHM) values of X-ray rocking curve (XRC) for the (002) plane of an Al-including III nitride film.

As mentioned above, in the case of fabricating an Al-including III nitride film by a MOCVD method, if the dew point of the inside of the reactor is monitored, the oxygen content to be incorporated in the film can be controlled. The dew point is measured with a dew point meter. The dew point meter involves the instruments that can measure the content of moisture as well as dew point.

When the Al-including III nitride film is fabricated by a MOCVD method, the dew point is set to a given value, depending on a desired oxygen content of the film.

The dew point can be controlled by flowing into the reactor an organic metal vapor including at least Al element. When using the organic metal vapor, the dew point can be precisely and effectively controlled in a short period.

As the Al-including organic metal, trimethylaluminum (TMA), triethylaluminum (TEA) or dimethylaluminum hydride (DMAH) are exemplified. In view of cost and dew point reducing effectiveness, TMA can be preferably usable.

Since the above-exemplified Al-including organic metal has its liquid state at room temperature, it is usually charged into a given container and bubbled to generate the organic metal vapor.

For preventing the deterioration of the crystallinity and thus, the deterioration of the optical and electrical properties of the Al-including III nitride film through the reduction of the oxygen content to be incorporated in the film, the dew point is set to a temperature of -90°C or below, preferably -95°C or below.

Fig. 1 is a graph showing the relation between the FWHM values of XRC for various Al-including III nitride film having the composition of AlₓGa_{y}In_{z}N (x+y+z=1, x≥0.7), which is epitaxially grown on a C-faced sapphire substrate by a MOCVD method, and the dew point. As apparent from Fig. 1, as the dew point of the reactor becomes -90°C or below, the FWHM values becomes 150 seconds or below, which is practical value to realize the practically optical and electrical properties of the film.

As the dew point becomes -95°C or below, the FWHM becomes 90 seconds or below. Therefore, the optical and electrical properties of the film can be more enhanced.

For setting the dew point of the reactor to a temperature of -90°C or below, the above-mentioned Al-including organic metal vapor is flown. For example, TMA vapor is flown at a rate of 10-50 µmol/min for 10-20 minutes, depending on the size of the reactor and the environmental condition. In this case, the amount of the moisture component in the reactor can be reduced to decrease the oxygen content to be incorporated in the Al-including III nitride film as the dew point is decreased.

After the dew point of the reactor is set to a predetermined value, the Al-including III nitride film is fabricated by normal process and condition of a MOCVD method.

Besides the C-faced sapphire substrate, another sapphire substrate having another main surface or another single crystal substrate may be employed. The same oxygen content-reducing effect can be realized for not only a single Al-including III nitride film directly formed on the substrate, but also plural Al-including III nitride films having their respective compositions to constitute a multi-layered structure formed on the substrate.

Moreover, the Al-including III nitride film is not required to have a large Al content, for example, 70 atomic percentages or over, as mentioned above, and may be allowable if it includes a small Al content. Preferably, the film includes Al content of 50 atomic percentages or over.

Then, for the use of a light-emitting diode, it is desired that the Al-including III nitride film has a composition of AlₓGa_{y}In_{z}N (x+y+z=1, x>0), particularly AlₓGa_{y}In_{z}N (x+y+z=1, x≥0.5) in light of the preferable Al content. Moreover, the film may contain additive element such B, Si, Mg.

The oxygen content to be incorporated in the Al-including III-nitride film is increased as the Al content therein is increased. Therefore, the fabricating method of the present invention can be applied for the film including a large Al content, for example, the film having the composition of (x+y+z=1, x≥0.5), particularly AlₓGa_{y}In_{z}N (x+y+z=1, x≥0.7).

### Examples:

### (Experiment 1 Forming part of the present invention.)

A C-faced sapphire single crystal substrate was employed, and then, set and attracted on a susceptor installed in a quartz reactor. TMA vapor was flown in the reactor at a rate of 10 µmol/min for 10 minutes to set the dew point of the reactor a temperature within -95°C through -90°C.

Then, the substrate was heated to various temperature up to the maximum temperature of 1150°C by the heater built in the susceptor, depending the kind of Al-including III nitride film to be fabricated. Subsequently, TMA vapor as an Al supply source, TMG vapor as a Ga supply source, trimethylindium (TMI) vapor as an In supply source and ammonia gas as a nitrogen supply source were supplied onto the substrate with hydrogen carrier gas at a given rate, thereby to fabricate various AlₓGa_{y}In_{z}N (x+y+z=1, x>0.7) films onto the substrate.

The crystallinity of each film was observed by X-ray diffraction, and the X-ray rocking curve was measured. Then, the thus obtained FWHM values of XRCs were plotted for their respective dew points, as shown in Fig. 1.
Herein, the fluctuation of the dew points from -90°C were neglected, and the measured FWHM values of XRC were plotted on the dew point of -90°C.

### (Experiment 2 forming part of the present invention.)

Prior to fabricating an Al-including III nitride film by a MOCVD method, TMA vapor was flown at a rate of 50 µmol/min for 20 minutes to set the dew point of the reactor to a temperature within -95°C through -100°C. Then, various AlₓGa_{y}In_{z}N (x+y+z=1, x>0.7) films were fabricated by the same manner as in Experiment 1.

The crystallinity of each film was observed by X-ray diffraction, and the X-ray rocking curve was measured. Then, the thus obtained FWHM values of XRC were plotted for their respective dew points, as shown in Fig. 1. Herein, the fluctuation of the dew points from -95°C were neglected, and the measured FWHM values of XRC were plotted on the dew point of -95°C.

### (Experiment 3 not forming part of the present invention: comparative example only.

The dew point of the reactor was set to a temperature within -80°C through -90°C without the flow of TMA vapor. Then, various AlₓGa_{y}In_{z}N (x+y+z=1, x>0.7) films were fabricated by the same manner as in Experiment 1.

The crystallinity of each film was observed by X-ray diffraction, and the X-ray rocking curve was measured. Then, the thus obtained FWHM values of XRC were plotted for their respective dew points, as shown in Fig. 1. Herein, the fluctuation of the dew points from -80°C were neglected, and the measured FWHM values of XRC were plotted on the dew point of -80°C.

From Experiments 1-3, it is turned out that the dew point of the reactor can be reduced through the flow of the TMA vapor, and as the flow rate and the flow period are increased, the dew point can be reduced. Moreover, it is turned out that the FWHM values of XRC for the Al-including III nitride film is reduced at a dew point of -90°C or below, resulting in the enhancement of the crystallinity of the film.

That is, if the TMA vapor is flown into the reactor before the fabrication of the Al-including III nitride film by a MOCVD method, the dew point of the reactor can be controlled and thus, the oxygen content to be incorporated in the film can be controlled. Accordingly, the crystallinity of the film is appropriately adjusted.

Although in the above Experiments, the C-faced sapphire single crystal substrate was employed, another sapphire single crystal substrate having another main surface or another single crystal substrate except the sapphire single crystal may be employed. Moreover, although the single Al-including III nitride film was formed directly on the substrate, a multi-layered structure constructed of plural Al-including III nitride film may be formed on the substrate. In this case, the crystallinity of each film can be enhanced.

Furthermore, in the above Experiments, the Al-including III nitride films have a large Al content of 70 atomic percentages. However, the same effect can be realized for an film having a smaller Al content, particularly 50 atomic percentages.

Although the present invention was described in detail with reference to the above examples, this invention is not limited to the above disclosure and variation and modification may be made without departing from the scope of the present invention, as defined by the appended claims.

As explained above, the dew point of the reactor to be used in a MOCVD method is monitored, and according to the present invention, the oxygen content to be incorporated in the Al-including III nitride film to be fabricated can be controlled. Therefore, if the dew point is set to a given value, the oxygen content can be reduced to a predetermined value, so that the crystallinity of the film can be enhanced.
A III nitride film including Al element is fabricated by a MOCVD method with monitoring the dew point of the reactor to be used in the MOCVD method. An organic metal vapor including at least Al element is flown in the reactor, and the dew point is
set to a temperature of -90°C or below. Then, the film is fabricated.

## Claims

1. A method for fabricating a III nitride film including at least Al element, comprising the steps of:
preparing a single crystal substrate in a reactor, and fabricating the III nitride film,
**characterized by**
setting the dew point of the reactor to a temperature of -90°C or below by flowing in the reactor an organic metal vapor including at least Al element, before the III nitride film is fabricated and after the single crystal substrate is set in the reactor.

2. A fabricating method as defined in claim 1, wherein the organic metal is trimethylaluminum.

3. A fabricating method as defined in any one of claims 1 or 2, wherein the III nitride film has a composition of AlₓGa_{y}In_{z}N (x+y+z=1 x≥0.5).

4. A fabricating method as defined in claim 3, wherein the III nitride film is an AlN film.

## Patentansprüche

1. Verfahren zum Herstellen eines III-Nitridfilms einschließlich zumindest eines Elements Aluminium, mit den Schritten:
Vorbereiten eines Einkristallsubstrats in einem Reaktor, und
Herstellen des III-Nitridfilms,
**gekennzeichnet durch**
Einstellen des Taupunkts des Reaktors auf eine Temperatur von -90°C oder darunter **durch** ein Fließen eines organischen Metalldampfes einschließlich zumindest eines Elements Aluminium in dem Reaktor, bevor der III-Nitridfilm hergestellt wird und nachdem das Einkristallsubstrat in den Reaktor gestellt wurde.

2. Herstellverfahren nach Anspruch 1, wobei das organische Metall Trimethylaluminium ist.

3. Herstellverfahren nach einem der Ansprüche 1 oder 2, wobei der III-Nitridfilm eine Zusammenzusetzung von AlₓGa_{y}In_{z}N mit (x+y+z=1, x≥0, 5) hat.

4. Herstellverfahren wie in Anspruch 3 definiert, wobei der III-Nitridfilm ein AlN Film ist.

## Revendications

1. Procédé de fabrication d'un film de nitrure III incluant au moins l'élément Al, comprenant les étapes de :
préparation d'un substrat monocristallin dans un réacteur, et
fabrication du film de nitrure III,
**caractérisé par**
la fixation du point de rosée du réacteur à une température de -90°C ou moins en faisant s'écouler dans le réacteur une vapeur de métal organique incluant au moins l'élément Al, avant que le film de nitrure III ne soit fabriqué et après que le substrat monocristallin a été disposé dans le réacteur.

2. Procédé de fabrication selon la revendication 1, dans lequel le métal organique est le triméthylaluminium.

3. Procédé de fabrication selon l'une quelconque des revendications 1 ou 2, dans lequel le film de nitrure III a une composition de AlₓGa_{y}In_{z}N (x+y+z = 1, x ≥ 0,5).

4. Procédé de fabrication selon la revendication 3, dans lequel le film de nitrure III est un film d'AlN.
